# EUROPEAN PATENT SPECIFICATION

(11) **EP 0 455 821 B1**
(45) Date of publication and mention of the grant of the patent: **03.03.1999**
(21) Application number: 90917101.9
(22) Date of filing: 21.11.1990
(51) Int. Cl.: H04B 1/06, H04B 1/16

(54) **RECEIVER**
EMPFÄNGER
RECEPTEUR

(30) Priority: 29.11.1989 JP 309679/89
(43) Date of publication of application: 13.11.1991
(73) Proprietor: MATSUSHITA ELECTRIC INDUSTRIAL CO., LTD., Kadoma-shi, Osaka-fu, 571 (JP)
(72) Inventor: KISHIMOTO, Yoshiteru 2-50, Ikenomiya 3-chome, Osaka 573 (JP); NINOMIYA, Shuichi 11-32, Higashikori Motomachi, Osaka 573 (JP); HIGUCHI, Kouichi 29-14, Higashinakaburi 1-chome, Osaka 573 (JP); YANO, Masayoshi 11-12, Ikagasakaemachi, Osaka 573 (JP)
(74) Representative: Dr. Elisabeth Jung Dr. Jürgen Schirdewahn Dipl.-Ing. Claus Gernhardt
(86) International application number: PCT/JP90/01517
(87) International publication number: WO 91/08618

(56) References cited:
- EP-A- 0 387 810
- DE-A- 3 040 465
- DE-A- 3 322 987
- DE-A- 3 733 028
- GB-A- 2 064 905
- JP-A- 5 769 924
- JP-A- 5 769 925
- JP-A- 5 862 922
- JP-A-58 188 938
- JP-A-61 123 321
- PATENT ABSTRACTS OF JAPAN vol. 7, no. 154 (E-185) 06 July 1983 & JP-A-58 062 922 (NISSAN JIDOSHA KK) 14 April 1983

## Description

### TECHNICAL FIELD

The present invention relates to a receiver of the kind defined by claim 1 such as a PLL synthesizer receiver which can selectively receive the frequency of a stored radiobroadcasting station.

### BACKGROUND ART

Conventionally, PLL synthesizer receivers are generally configurated as shown in Fig. 12. That is, with regard to a receiving circuit 21, a PLL circuit 22 for selecting the receiving frequency is provided, and the frequency dividing ratio of a programmable frequency divider of this PLL circuit 22 is controlled by a controlling means 23, and thereby receiving is performed at a desired receiving frequency. Numeral 24 designates an operating means for performing operating input to the means for performing operating input to the above-mentioned controlling means 23, numeral 25 designates a storing means for storing desired frequencies of radiobroadcasting stations, and numeral 26 designates a display unit of frequency and the like. Here, the above-mentioned operating means 24 comprises a band key for selecting a frequency band for selecting a receiving frequency of a station, a station select key for performing up/down of the frequency, and further a memory key for writing for preset memory, and read keys such as a scroll key for reading stored frequencies (or a select key of a required number of memories).

Then, a radiobroadcasting station of a desired receiving frequency is selected and listened to by the band key 24 and the station select key of the operating means 24, and the selected receiving frequency is written to the storing means 25 by the memory key to be set as a preset memory, and the preset receiving frequency is read by operating the read key, and thereby receiving can be made.

However, in the above-mentioned conventional receiver, the receiving frequencies of the desired radiobroadcasting stations are stored in advance in the storing means, and can be read at any time as required to be received promptly, but, for example, in the case where this receiver is used in another geographic area (referred to in the following as "area") on a private or business trip, the receiving frequencies of the radiobroadcasting stations which have been preset in advance cannot be used, and a troublesome receiving operation has to be made while searching the frequency of the radiobroadcasting station in that area. At this time, where the frequency of the radiobroadcasting station in that area is unknown, there is no means other than searching for the frequency while varying the frequency in sequence.

A receiver of the kind defined by the precharacterizing features of claim 1 is known from the GB-A-2 064 905.

A similar receiver is known from the EP-A-0 387 810 which is adapted to imply a continuous sweep for automatically tuning radio broadcasting stations.

In the evaluation of prior art in DE-A-30 40 465 a receiver is disclosed comprising a data memory having stored therein data, particularly tuning data of broadcasting stations to be received from an area, wherein at a location in a sub-region of said area only a part of the stored broadcasting stations can be received with a sufficient field strength, means for manually inputting information upon said location adapted to allow selection out of said stored broadcasting stations which then can be recalled for tuning purposes. In the invention according to DE-A-30 40 465 the frequencies of receivable broadcasting stations are determined when the receiver is in a specific operation state serving to initialize the receiver and said location is derived from a determined combination of the receivable broadcasting stations.

Said specific operating state is respectively set when the mains plug supplying current to the device is put off. The described operating state of the receiver serving to determine the information on the location can respectively be triggered when the device is switched on, however, it also makes sense to set this operating state only in case the mains plug of the device has been disconnected. In addition, the operating state may be triggered by actuation of a button.

### DISCLOSURE OF THE INVENTION

In the light of the conventional problem as described above, the present invention has been made for the purpose of providing a receiver of the kind defined by the precharacterizing features of claim 1 which can promptly select the frequency of the radiobroadcasting station of an area even on a Journey or business trip thereto, can be operated easily, and can write frequencies of arbitrary broadcasting stations.

This object is attained by the characterizing features of claim 1.

In order to solve the above-mentioned problem, the receiver of the present invention
(1) comprises a first storing means for storing frequencies of radiobroadcasting stations in each of a plurality of areas, a second storing means capable of storing frequencies of arbitrary radiobroadcasting stations, a selection operating means for selecting the frequency of the necessary radiobroadcasting station from the above-mentioned first storing means and second storing means, and a station selection controlling means for making it possible to receive the frequency of a radiobroadcasting station in the desired area which is stored as mentioned above in correspondence to a selection of this selection operating means.
(2) The above-mentioned selection operating means comprises a first selection operating means for selecting an area, and a second selection operating means for selecting the frequency of the necessary radiobroadcasting station in that area.
(3) The above-mentioned receiver comprises a display unit having an area name display part of a plurality of areas, a receiving frequency display part and/or a radiobroadcasting station name display part, whereby each part is configurated so as to be capable of selective display.
(4) The station selection controlling means is so configurated that area selection by the first selection operating means is made possible only in non-receiving state.
(5) The station selection controlling means is so configurated as to control in a manner that frequency selection by the station select switch is stopped when a selection by the first selection operating means selects an area of the first storing means, and an arbitrary selection of the receiving frequency by the station select switch is made possible when the second storing means is station-selected.

In the present invention, according to the above-mentioned configuration, frequencies of radiobroadcasting stations in an appropriate area stored on a receiving area basis can be selected by the selection operating means, and area selection is performed by the first selection operating means, and memory selection of the desired radiobroadcasting station is performed by the second selection operating means. Also, an area, frequency and/or a name of radiobroadcasting station corresponding to a selection by the selection operating means are displayed obviously on a display unit.

Furthermore, area selection by the first selection operating means is performed only in non-receiving state, and thereby an arbitrary change of the radiobroadcasting station by a wrong operation of the first selection operating means during receiving can be prevented.

### BRIEF DESCRIPTION OF THE DRAWINGS

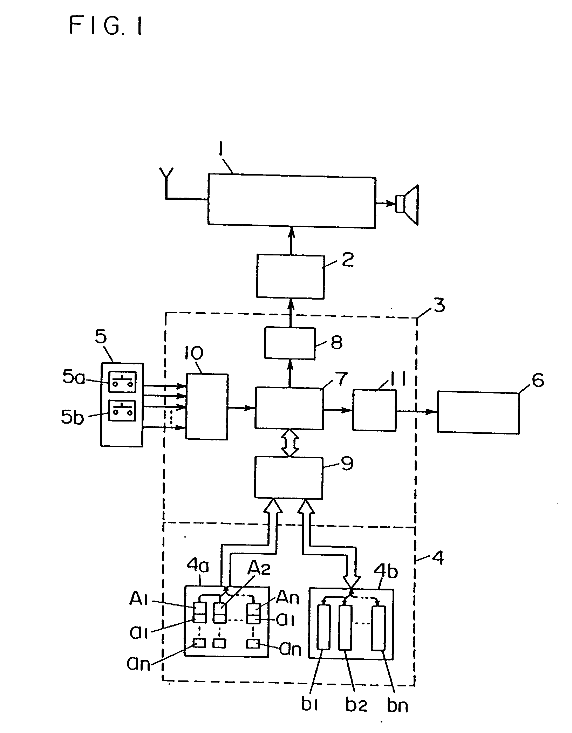

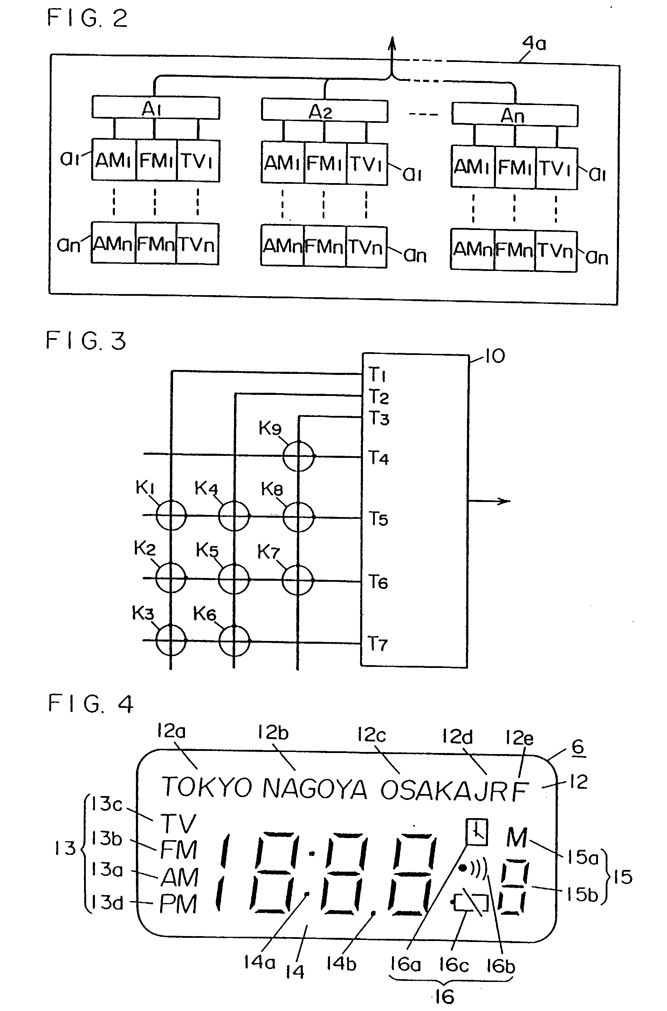

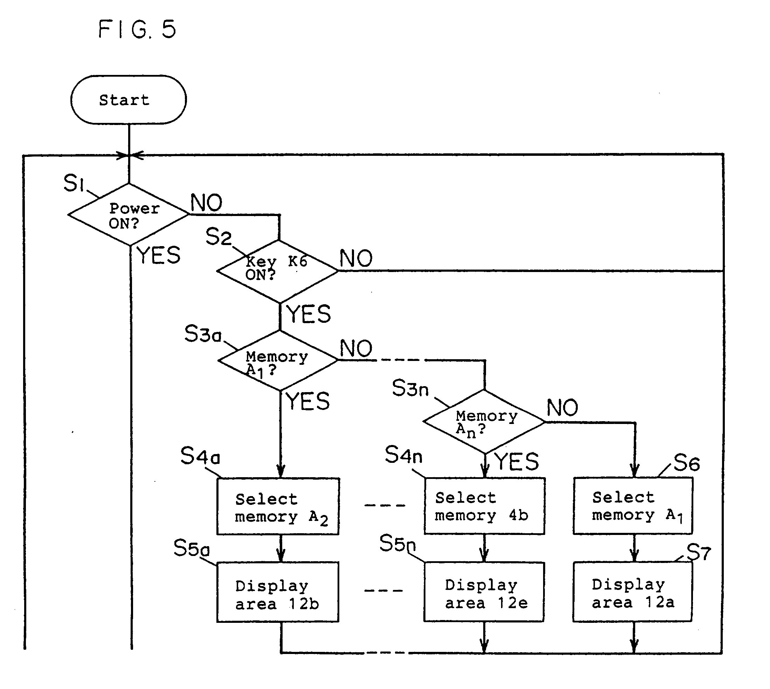

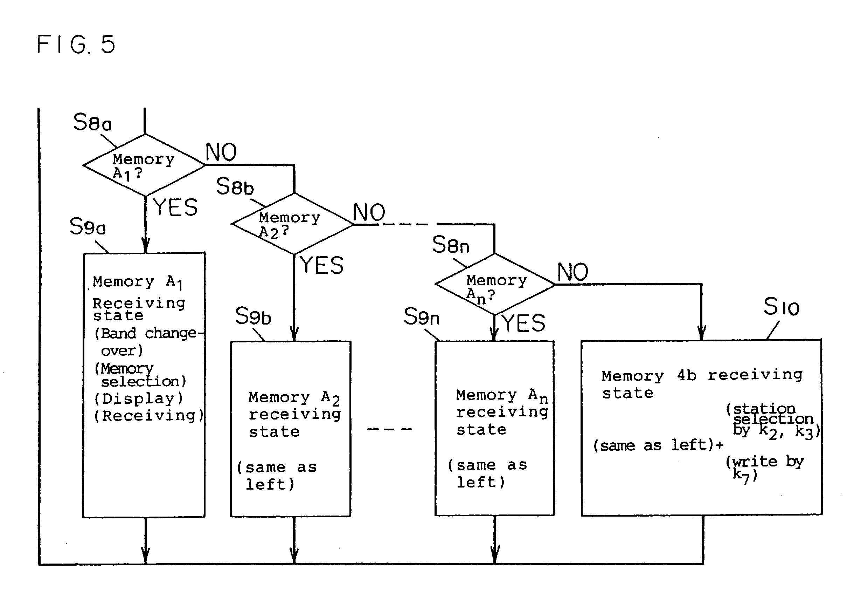

Fig. 1 is a block diagram showing a first embodiment of a receiver of the present invention, Fig. 2 is a memory configuration view of a first storing means of the same, Fig. 3 is a circuit diagram showing a specific example of a selection operating means of the same, Fig. 4 is a front view showing a configuration of display parts of a display unit of the same, Fig. 5 is a flowchart of the same.

### THE BEST MODE FOR CARRYING OUT THE INVENTION

Hereinafter, description is made on a first embodiment of a receiver of the present invention in reference to drawings. Fig. 1 is a block diagram thereof, Fig. 2 is a configuration view of a first storing means, Fig. 3 is a configuration view of a selection operating means, and Fig. 4 is a front view showing display of a display unit.

In the drawings, numeral 1 designates a receiving circuit, and numeral 2 designates a PLL circuit determining the receiving frequency thereof, and the receiving frequency, that is, the radiobroadcasting station is determined by controlling the frequency dividing ratio of a programmable frequency divider of this PLL circuit 2. Numeral 3 designates a station selection controlling means for controlling the above-mentioned PLL circuit 2, numeral 4 designates a memory, numeral 5 designates a selection operating means for selecting the frequency of the receiving radiobroadcasting station, numeral 6 designates a display unit, and in correspondence to an operation of the selection operating means 5, the station selection controlling means 3 outputs a control command of the receiving frequency to the PLL circuit 2 and a required display command to the display unit 6, and performs a command of a write to or a read from the memory 4.

The above-mentioned controlling means 3 comprises a CPU 7, a PLL controlling means 8 for controlling specifically the frequency dividing ratio of the above-mentioned PLL circuit 2 by a command of the CPU 7, a memory inputting/outputting means 9 for writing or reading the receiving frequency to or from the memory 4 by a command of the above-mentioned CPU 7, an operation inputting means 10 for sending a code signal to the CPU 7 in correspondence to an operation of the above-mentioned operation part 5, and a display unit driving means 11 for performing display control of the display unit 6 by a command of the above-mentioned CPU 7.

The above-mentioned memory 4 comprises a first storing means 4a for storing the area and the frequencies of the radiobroadcasting stations in that area for each of a plurality of areas, and a second storing means 4b which can write or read the frequencies of arbitrary radiobroadcasting stations. Then, the above-mentioned first storing means 4a has an area memory group A₁ - Aₙ and a frequency memory group a₁ - aₙ of radiobroadcasting stations on an area basis which are stored in each of the area memory group A₁ - Aₙ, and the second storing means 4b has a frequency memory group b₁ - bₙ which can be written or read arbitrarily. Furthermore, the above-mentioned area memory group A₁ - Aₙ, as shown in Fig. 2, has a frequency memory group a₁ - aₙ in each frequency band of the AM band, FM band and the TV band, and these are determined properly depending on the number of radiobroadcasting stations in each area A₁ - Aₙ, being stored in advance. This memory is configurated in a read-only type which cannot be re-written, and this configuration prevents a re-write by mistake of a memory of an area of unknown receiving frequency for the frequency of the radiobroadcasting station which differs on an area basis.

Next, the above-mentioned selection operating means 5 comprises a first selection operating 5a for selecting the area memory group A₁ - Aₙ stored in the above-mentioned first storing means 4a and the second storing means 4b capable of free presetting, and a second selection operating means 5b for selecting the above-mentioned stored frequency group a₁ - aₙ or b₁ - bₙ, that is, the frequency of the necessary radiobroadcasting station. Here, the second selection operating means 5b has band switches for switching-over the frequency bands of Am band, FM band and TV band, and a memory select switch which selects and reads a desired stored frequency from the frequency memory group a₁ - aₙ and b₁ - bₙ in each band, and the memory select switch for read is configurated with a scroll system by one key or a plurality of specific keys. Also, it has a station select switch consisting of an up/down switch which can arbitrarily select the receiving frequency when the second storing means 4b is selected by the above-mentioned first selection operating means 5a, and a memory switch for writing the frequency of an arbitrary desired radiobroadcasting station to the second storing means 4b. Furthermore, it has a power switch for making ON/OFF of the power source and other necessary operation switches.

Fig. 3 shows an example wherein the selection operating means 5 is configurated with matrix key switches. This means that it has keys K₁ - K₉ and terminals T₁ - T₇ for giving a signal input to the above-mentioned operation inputting means 10 in correspondence to a push thereof, and the operation inputting means 10 generates a code signal corresponding to a short-circuit of the terminals T₁ - T₇ by a push of the key K₁ - K393. Here, K₁ designates a power switch key, K₂ and K₃ designate station select UP/DOWN keys, K₄ designates a band switch key, K₅ designates an area select switch key, and K₇ designates a memory switch key for write. Then, the key K₆ is equivalent to the above-described first selection operating means 5a, and the band switch key K₄ and the memory select switch key K₅ are equivalent to the second selection operating means 5b, and after selecting an area by the key K₆, switching to a desired band by the key K₄ and selection of a desired radiobroadcasting station are performed. In addition, by the keys K₈ and K₉ and the operating means using the keys K₉ and K₇, and by a clock means provided in the station selection controlling means 3, a timer and an alarming function as described later are provided.

Next, description is made on the above-mentioned display unit 6 in reference to Fig. 4. The display unit has an area display part 12 showing the receiving area, a band and/or AM/PM display part 13, a frequency or time display part 14, a memory channel display part 15, and a display part 16 of other functions. The above-mentioned area display part 12 displays TOKYO 12a, NAGOYA 12b, OSAKA 12c, JR NEW SUPEREXPRESS (Shinkansen) LINE 12d and FREE 12e, and TOKYO 12a - JR NEW SUPEREXPRESS LINE 12d are equivalent to the displays of the area memory group A₁ - Aₙ in the above-described first storing means 4a, and FREE 12e is equivalent to the display of the second storing means 4b. The above-mentioned display part 13 has receiving band display parts of AM band 13a, FM band 13b and TV band 13c as a band display in receiving, and display parts of forenoon AM 13a as clock display (used also for the AM band in receiving) and afternoon PM 13d. The above-mentioned display part 14 has segments for numeric display, a colon 14a for time display and a dot 14b for displaying decimal point in frequency display, and displays the time in non-receiving state, displays the frequency (KHz or MHz) in An or FM receiving, and displays the channel (1 - 12ch) in TV receiving, respectively. Also, the above-mentioned display part 15 displays the memory channel of the frequencies (the above-mentioned a₁ - aₙ or b₁ - bₙ) which are stored in each of the memory groups A₁ - Aₙ and 4b in selection on the above-mentioned area display part 12a - 12d and free display part 12e, and has a display M 15a showing the memory receiving state and a memory channel display part 15b. The above-mentioned display part 16 for other functions has a display 16a showing setting of alarm time, a display 16b showing an alarm of expiration of a predetermined time, and a display 16c showing an alarm of reduction in voltage, that is, replacement of battery.

Here, description is made on the relation to the clock function in reference to Fig. 3 and Fig. 4. When the power switch key K₁ is turned off, the display part 13 shows forenoon and afternoon of the time by the display parts 13a and 13b, and the display part 14 displays a time 12:00 - 11:59. Then, the current time can be adjusted by pushing the up/down keys K₂ and K₃ while pushing the time set key K₇ used also for the above-mentioned memory. Furthermore, an alarm of expiration of a predetermined time is set by pushing the alarm key K₈, and the setting thereof is displayed by lighting the above-mentioned display 16b, and an appropriate predetermined time (1 - 180 minutes) can be set by pushing the up/down keys K₂ and K₃ while pushing the key K₈. Also, the alarm time can be adjusted by changing the current time on the display part 14 to the alarm time by pushing the stand-by key K₉, and pushing the up/down keys K₂ and K₃ while pushing the key K₉, and by releasing the push of the key K₉, the display 16a is lit to show the setting.

Next, description is made on the station selecting operation based on a flowchart in Fig. 5. First, in Step S₁, whether power is put in ON state or OFF state by the key K₁ is judged, and when power is in OFF state, processing proceeds to Step S₂, and On or OFF of the area select key K₆ is judged, and when it is OFF, processing returns to the former step, and by turning on the key K₆, processing proceeds to the next step S₃. In this step S₃ₐ, judgment is made on whether or not the area memory A₁ is first selected among the area memory group A₁ - Aₙ when the key K₆ is turned on (note that n=4 in the embodiment as shown in Fig. 4), and when A₁ is selected, the next area memory A₂ is selected in Step S₄ₐ, and the area display part 12b is lit in Step S₅ₐ. On the other hand, when A₁ is not selected in this step S₃ₐ, processing proceeds to the next step S_{3b} (not illustrated), and proceeds up to Step S₃ₙ in sequence by similar judgments, and where judgment results in YES in Steps S_{3b} - S₃ₙ like the above-mentioned case, the memory groups A₃ - Aₙ and 4b are selected in Steps S_{4b} - S₄ₙ, and the area display parts 12c - 12e are lit in Steps S_{5b} - S₅ₙ. Then, where judgment results in NO in Step S₃ₙ, the area memory A₁ is selected in Step S₆. and the area display part 12a is lit in Step S₇. This means that in the power-off state, the memory groups A₁ - Aₙ and 4b can be changed-over every time of push of the area select key K₆ (in other words, the first selection operating means 5a), and the area display parts 12a - 12e can be displayed in a sequential change-over fashion, and any of them is lit all the time.

Then, in the above-mentioned Step S₁, when power is put in ON state by pushing the key K₁, receiving is made possible, and processing proceeds to Step S₈ₐ. In this Step S₈ₐ, judgment is made on whether or not A₁ is selected from among the area memory group A₁ - Aₙ, and when A₁ is selected, processing proceeds to the next Step S₉ₐ, and the state of receiving the area memory A₁ is brought. In this Step S₉ₐ, selection of receiving frequency of the desired radiobroadcasting station in the appropriate area is performed by band switch-over by an operation of the key K₄ and selection from the frequency memories a₁ - aₙ by an operation of the key K₅, and the band displays 13a - 13c, the frequency display 14, and the memory channel display 15b are performed, and thereby receiving of that radiobroadcasting is made possible. On the other hand, when judgment results in NO in Step S₈ₐ, processing proceeds sequentially to Steps S_{8b} - S₈ₙ, and judgment is made on whether or not the selected areas are the area memory A₂ - Aₙ respectively, and when the selected areas are A₂ - Aₙ, processing proceeds to Steps S_{9b} - S₉ₙ, and in these Steps S_{9b} - S₉ₙ, actions similar to that in Step S₉ₐ, that is, selective receiving and display are performed in the respective area memories A₂ - Aₙ. Furthermore, when judgment results in NO in Step S₈ₙ, processing proceeds to Step S₁₀, the receiving state of the storing means 4b is brought (that is, FREE state), and selection of the frequency memories b₁ - bₙ is performed like the above-mentioned case, and in this Step S₁₀, up/down selection of the receiving frequency by the keys K₂ and K₃ is possible, and a desired frequency can be written (re-written) arbitrarily to the memories b₁ - bₙ by an operation of the key K₇.

### APPLICABILITY IN INDUSTRIES

The present invention is configurated as described above, and by storing radiobroadcasting stations in a plurality of areas in advance, the radiobroadcasting station can be selected easily and reliably by a simple operation without selecting the station while taking the trouble of scrolling frequencies even if the receiving frequency is unknown in the case of visiting the appropriate area on a private or business trip or the like, and memory and selection of even more radiobroadcasting stations can be performed by the storing means capable of arbitrarily storing.

Furthermore, the first selection operating means for selecting the area and the second selection operating means for selecting the frequency of the stored radiobroadcasting station are provided, and displays thereof are performed, and thereby a receiver can be obtained which is more reliable and easy to find the current receiving state, and is more convenient by displaying the name of radiobroadcasting station.

Furthermore, selection of the area by the first selection operating means is made possible only in the non-receiving state, and thereby even if the first selection operating key is operated by mistake in the state of station selection receiving, a generation of such problem can be prevented that the receiving changes to that of another station, causing a confusion.

## Claims

1. A receiver capable of selectively receiving the frequency of a stored radiobroadcasting station, comprising:
a first storing means (4a) for storing the frequencies of radiobroadcasting stations in each of a plurality of geographic areas,
a second storing means (4b) capable of storing the frequencies of arbitrary radiobroadcasting stations,
a selection operating means (5a, 5b) having a first selection operating means (5a) for selecting a geographic area, and a second selection operating means (5b) for thereafter selecting the frequency of a desired radiobroadcasting station from said first storing means (4a) in said selected geographic area and
a station selection controlling means (3) adapted to receive the frequency of the desired radiobroadcasting station which is stored in correspondence to a selection by the selection operating means (5a, 5b),
characterized in that the station selection controlling means (3) is configurated so that selection of a geographic area by the first selection operating means (5a) is made possible only in the non-receiving state.

2. A receiver in accordance with claim 1,
characterized in that a display unit (6) having a geographic area name display part (12) for a plurality of said areas and a receiving frequency display part (14) is provided, and when the first selection operating means (5a) is operated, the name of the geographic area is selectively displayed on the geographic area name display part (12) in correspondence to that selecting operation, and when the second selection operating means (5b) is operated, the frequency of the selected radiobroadcasting station is selectively displayed on the receiving frequency display part (14).

3. A receiver in accordance with claim 1,
characterized in that a display unit (6) having a geographic area name display part (12) for a plurality of said areas and a receiving radiobroadcasting station name display part (14) is provided, and when the first selection operating means (5a) is operated, the area name is selectively displayed on the area name display part (12) in correspondence to that selecting operation, and when the second selection operating means (5b) is operated, the name of the radiobroadcasting station is selectively displayed on the radiobroadcasting station name display part (14).

4. A receiver in accordance with claim 1,
characterized in that the station selection controlling means (3) is configurated so that when a geographic area in the first storing means (4a) is selected by the first selection operating means (5a), selection of the receiving frequency by the station selection controlling means (3) is stopped, and when the second storing means (4b) is selected, an arbitrary selection of the receiving frequency by the station selection controlling means (3) is possible, and the desired arbitrary receiving frequency can be written to the second storing means (4b).

## Patentansprüche

1. Empfänger zum wahlweisen Empfangen der Frequenz einer gespeicherten Rundfunkstation, aufweisend:
Eine erste Speichereinrichtung (4a) zum Speichern der Frequenzen von Rundfunkstationen in jedem einer Mehrzahl von geographischen Bereichen,
eine zweite Speichereinrichtung (4b) zum Speichern der Frequenzen von beliebigen Rundfunkstationen,
eine Wahlbetätigungseinrichtung (5a, 5b) mit einer ersten Wahlbetätigungseinrichtung (5a) zum Wählen eines geographischen Bereichs und einer zweiten Wahlbetätigungseinrichtung (5b), um daraufhin die Frequenz einer gewünschten Rundfunkstation aus der ersten Speichereinrichtung (4a) in dem gewählten geographischen Bereich zu wählen, und
eine Stationswahlsteuereinrichtung (3), die dazu ausgelegt ist, die Frequenz der gewünschten Rundfunkstation zu empfangen, die in Übereinstimmung mit einer Wahl durch die Wahlbetätigungseinrichtung (5a, 5b) gespeichert ist,
dadurch gekennzeichnet, daß die Stationswahlsteuereinrichtung (3) so aufgebaut ist, daß die Wahl eines geographischen Bereichs durch die erste Wahlbetätigungseinrichtung (5a) ausschließlich im Nicht-Empfangszustand ermöglicht ist.

2. Empfänger nach Anspruch 1, dadurch gekennzeichnet, daß eine Anzeigeeinheit (6) mit einem Anzeigeteil (12) für einen geographischen Bereichsnamen für mehrere der Bereiche und einen Empfangsfrequenzanzeigeteil (14) vorgesehen ist, und wenn die erste Wahlbetätigungseinrichtung (5a) betätigt ist, wird der Name des geographischen Bereichs wahlweise auf dem Anzeigeteil (12) für den geographischen Bereichsnamen in Übereinstimmung mit diesem Wahlvorgang angezeigt, und wenn die zweite Wahlbetätigungseinrichtung (5b) betätigt ist, wird die Frequenz der gewählten Rundfunkstation wahlweise auf dem Anzeigeteil (14) für die Empfangsfrequenz angezeigt.

3. Empfänger nach Anspruch 1, dadurch gekennzeichnet, daß eine Anzeigeeinheit (6) mit einem Anzeigeteil (12) für einen geographischen Bereichsnamen für mehrere der Bereiche und einen Anzeigeteil (14) für den Namen einer empfangenen Rundfunkstation vorgesehen ist, und wenn die erste Wahlbetätigungseinrichtung (5a) betätigt ist, wird der Bereichsname auf dem Bereichsnamenanzeigeteil (12) in Übereinstimmung mit diesem Wahlvorgang angezeigt, und wenn die zweite Wahlbetätigungseinrichtung (5b) betätigt ist, wird der Name der Rundfunkstation wahlweise auf dem Rundfunkstationsnamenanzeigeteil (14) angezeigt.

4. Empfänger nach Anspruch 1, dadurch gekennzeichnet, daß die Stationswahlsteuereinrichtung (3) so aufgebaut ist, daß dann, wenn ein geographischer Bereich in der ersten Speichereinrichtung (4a) durch die erste Wahlbetätigungseinrichtung (5a) gewählt ist, die Wahl der Empfangsfrequenz durch die Stationswahlsteuereinrichtung (3) gestoppt wird, und wenn die zweite Speichereinrichtung (4b) gewählt ist, eine beliebige Wahl der Empfangsfrequenz durch die Stationswahlsteuereinrichtung (3) möglich ist und die gewünschte beliebige Empfangsfrequenz kann in die zweite Speichereinrichtung (4b) geschrieben werden.

## Revendications

1. Récepteur capable de recevoir sélectivement la fréquence d'une station de radio-diffusion mémorisée, comprenant :
un premier moyen de mémorisation (4a) pour mémoriser les fréquences des stations de radio-diffusion dans chacune d'une pluralité de zones géographiques,
un second moyen de mémorisation (4b) capable de mémoriser des stations de radio-diffusion arbitraires, un moyen de mise en oeuvre de sélection (5a, 5b) comportant un premier moyen de mise en oeuvre de sélection (5a) pour sélectionner une zone géographique et un second moyen de mise en oeuvre de sélection (5b) pour, par la suite, sélectionner la fréquence d'une station de radio-diffusion désirée à partir dudit premier moyen de mémorisation (4a) dans ladite zone géographique sélectionnée et
un moyen de commande de sélection de station (3) conçu pour recevoir la fréquence de la station de radio-diffusion désirée qui est mémorisée en correspondance avec une sélection par le moyen de mise en oeuvre de sélection (5a, 5b),
caractérisé en ce que le moyen de commande de sélection de station (3) est configuré de sorte que la sélection d'une zone géographique par le premier moyen de sélection (5a) est rendue possible seulement à l'état de non-réception.

2. Récepteur selon la revendication 1, caractérisé en ce qu'un unité d'affichage (6) comportant une partie d'affichage de nom de zone géographique (12) pour une pluralité desdites zones et une partie d'affichage de fréquence de réception (14) est prévue, et lorsque le premier moyen de mise en oeuvre de sélection (5a) est activé, le nom de la zone géographique est visuellement affiché sur la partie d'affichage de nom de zone géographique (12) en correspondance avec cette opération de sélection et lorsque le second moyen de mise en oeuvre de sélection (5b), est activé, la fréquence de la station de radio-diffusion sélectionnée est affichée sélectivement sur la partie d'affichage de réception (14).

3. Récepteur selon la revendication 1, caractérisé en ce qu'une unité d'affichage (6) comportant une partie d'affichage de nom de zone géographique (12) pour une pluralité desdites zones et une partie d'affichage de noms de station de radio-diffusion et de réception (14) est prévue, et lorsque le premier moyen de mise en oeuvre de sélection (5a) est activé, le nom de la zone est sélectivement affiché sur la partie d'affichage de nom de zone (12) en correspondance avec cette opération de sélection et lorsque le second moyen de mise en oeuvre de sélection (5b) est activé, le nom de la station de radio-diffusion est sélectivement affiché sur la partie d'affichage de nom de station de radio-diffusion (14).

4. Récepteur selon la revendication 1, caractérisé en ce que le moyen de commande de sélection de station (3) est configuré, de sorte que lorsqu'une zone géographique dans le premier moyen de mémorisation (4a) est sélectionnée par le premier moyen de sélection (5a), la sélection de la fréquence de réception par le moyen de commande de sélection de station (3) est arrêtée, et lorsque le second moyen de mémorisation (4b) est sélectionné, une sélection arbitraire de la fréquence de réception par le moyen de commande de sélection (3) est possible et la fréquence de réception arbitraire désirée peut être écrite dans le second moyen de mémorisation (4b).
